Europäisches Patentamt

European Patent Office

Office européen des brevets

(19)

(11) Veröffentlichungsnummer: **0 010 134**
**B1**

(12) # EUROPÄISCHE PATENTSCHRIFT

(45) Veröffentlichungstag der Patentschrift:
**27.04.83**

(21) Anmeldenummer: **79103071.1**

(22) Anmeldetag: **21.08.79**

(51) Int. Cl.³: **G 11 C 19/28,** G 11 C 27/02,
H 01 L 27/10

(54) **Ladungsverschiebespeicher in Seriell-Parallel-Seriell-Organisation mit vollständigem Grundladungsbetrieb.**

(30) Priorität: **02.10.78 DE 2842856**

(43) Veröffentlichungstag der Anmeldung:
**30.04.80 Patentblatt 80/9**

(45) Bekanntmachung des Hinweises auf die Patenterteilung:
**27.04.83 Patentblatt 83/17**

(84) Benannte Vertragsstaaten:
**FR GB NL**

(56) Entgegenhaltungen:
EP-A-0 009 598
US-A-3 763 480
US-A-3 824 337
US-A-3 947 698
US-A-3 967 254
US-A-3 980 902
US-A-4 001 501
US-A-4 055 836
US-A-4 117 546
US-A-4 125 786

IEEE JOURNAL OF SOLID STATE CIRCUITS, Vol. SC-12, Nr. 4, August 1977, New York, US, KOHYAMA et al.: «A new multiplexed electrode-per-bit structure for a 64-Kbit charge-coupled-device memory», Seiten 335–343

(73) Patentinhaber: **SIEMENS AKTIENGESELLSCHAFT,**
**Berlin und München Wittelsbacherplatz 2,**
**D-8000 München 2 (DE)**

(72) Erfinder: **Grüter, Otto, Dr.rer.nat., Berchemstrasse 17,**
**D-8033 Krailling (DE)**

IBM TECHNICAL DISCLOSURE BULLETIN, Vol. 21, Nr. 5, Oktober 1978, Armonk, US, CASES et al.: «Charge-Coupled device memory organization», Seiten 1904–1907

IEEE JOURNAL OF SOLID-STATE CIRCUITS, Vol. SC9, Nr. 6, Dezember 1974, New York, US, KRAMBECK et al.: «A 4160-bit C4D serial memory», Seiten 436–443

WESCON TECHNICAL PAPERS, Nr. 18, 1974, Hollywood, US, KOSONOCKY: «Charge-coupled devices, an overview», Seiten 2/1–1 bis 2/1–20

CHARGE TRANSFER DEVICES, Academic Press, 1975, New York, US, SEQUIN & TOMPSETT: «Digital memories», Seiten 236–301

Ladungsverschiebespeicher in Seriell-Parallel-Seriell-Organisation mit vollständigem Grundladungsbetrieb.

Die Erfindung betrifft einen Ladeverschiebespeicher in Seriell-Parallel-Seriell-Organisation mit Grundladungsbetrieb, bei dem eine Einlesekette aus abwechselnd hintereinander angeordneten ersten und zweiten Ladungsverschiebeelementen vorgesehen ist, bei dem den ersten Ladungsverschiebeelementen jeweils eine Parallelkette zugeordnet ist, in die die Informationen kennzeichnenden Ladungen aus der Einlesekette über von einer Übernahmeelektrode gesteuerte Ladungsverschiebeelemente übernommen werden, bei dem eine Auslesekette aus jeweils abwechselnd hintereinander angeordneten ersten und zweiten Ladungsverschiebeelementen vorgesehen ist, wobei die Ladungen aus den Parallelketten über von einer Übergabeelektrode gesteuerten Ladungsverschiebeelement in die ersten Ladungsverschiebeelemente der Auslesekette übergeben werden, und bei dem in das in Schieberichtung erste Ladungsverschiebeelement der Einlesekette Grundladungen und Informationsladungen einführbar sind.

Ein derartiger Ladungsverschiebespeicher in Serie-Parallel-Serien Organisation ist aus der US-A-3 980 902 bekannt.

Grundladungsbetrieb bei Ladungsverschiebespeichern ist bekannt. So wird in dem Buch «Charge Transfer-Devices», Sequin, Tompsett, Academic Press, New York, San Francisco, London, 1975, von S. 97–109 der Grundladungsbetrieb bei Oberflächenladungsverschiebespeichern zur Verminderung der schädlichen Einflüsse, welche die Oberflächenzustände auf die Signalleitungen ausüben, beschrieben.

Bei Ladungsverschiebespeichern bemüht man sich, mit Hilfe des Grundladungsbetriebes, das Entleeren der Oberflächenzustände für bewegliche Ladungsträger zu verhindern. Insbesondere beim Verschieben von sogenannten leeren Potentialtöpfen, die sich im thermodynamischen Ungleichgewichtszustand befinden, verändern sich die Oberflächenzustände und geben an die Potentialtöpfe Ladungen ab, so dass sich diese in unerwünschter Weise allmählich füllen. Das führt dazu, dass beim anschliessend eventuellen Durchlaufen von gefüllten Ladungstöpfen diese sich wieder entsprechend leeren, weil sich die ursprünglichen Oberflächenzustände beim Angebot von Ladungen wieder auffüllen und damit den Potentialtöpfen Ladungen entziehen.

Ein Grundladungsbetrieb ist insbesondere bei Ladungsverschiebebausteinen mit Oberflächen CCDs in Doppelsiliziumtechnologie notwendig, um sicherzustellen, dass z.B. im 2-Phasen-Betrieb jeweils nur die Zwischenspeicherstellen leer sind, nicht jedoch auch die Speicherstellen, die die Information «0» tragen, d.h. mit keiner Informationsladung gefüllt sind.

Bei derartigen Speicherbausteinen ist eine Eingabeschaltung vorgesehen, die die Grundladungen zusammen mit den Informationsladungen in die eigentliche Speicherkette einspeichert. Auf diese Weise wird jedoch nur für Grundladungsbetrieb längs des eigentlichen Informationsflussweges gesorgt, das bedeutet, dass sämtliche Kanäle eines Parallelfeldes innerhalb einer Seriell-Parallel-Seriell-Anordnung ständig mindestens mit der Grundladung gefüllt sind.

Werden bei Seriell-Parallel-Seriell-Ladungsverschiebespeichern die seriell eingelesenen Informationsladungen der Eingabe-Seriellkette in das Parallelfeld übernommen, so ist nach dieser Übernahme die Eingabe-Seriellkette zunächst vollkommen ohne Ladungen. Erst anschliessend wird sie von der Eingabeschaltung her allmählich wieder aufgefüllt. Dies führt dazu, dass die eingelesenen Informationsladungspakete durch die teilweise entleerten Oberflächenzustände schädlich vermindert werden.

Analoges gilt für die Ausgabe-Seriellkette von Ladungsverschiebespeichern in Seriell-Parallel-Seriell-Organisation. Nach dem Übergeben der Informationsladungen aus dem Parallelfeld in die Ausgabe-Seriellkette wird letztere mit dem Abfliessen der Informationsladungen in die Ausgabeschaltung zunehmend entleert. Unmittelbar vor dem nächsten Übergabevorgang sind sämtliche Ladungsverschiebeelemente der Ausgabe-Seriellkette vollkommen ausgeräumt. Aus den Oberflächenzuständen herrührend, füllen sich die leeren Ladungsverschiebeelemente hintereinander in Richtung der Ausgabeschaltung hin mit schädlichen Störladungen an. In Gegenrichtung werden damit Oberflächenzustände frei, wobei sich beide Prozesse störend auf die aus dem Parallelfeld neu zu übergebenden Informationsladungen auswirken.

Die der Ausgabeschaltung fernen Ladungen werden durch das Wiederauffüllen der leeren Oberflächenzustände unzulässig vermindert. Damit ergibt sich, insbesondere zwischen der ersten und der letzten Informationsladung zweier aufeinanderfolgender Übergabevorgänge eine unzulässig grosse Ladungsdifferenz.

Der Erfindung liegt die Aufgabe zugrunde, einen Ladungsverschiebespeicher in Seriell-Parallel-Seriell-Organisation mit Grundladungsbetrieb bereitzustellen, der einen vollständigen Grundladungsbetrieb sowohl in den Parallelketten als auch in den seriellen Ein-/Ausgabeketten ermöglicht.

Diese Aufgabe wird gemäss der Erfindung dadurch gelöst, dass den zweiten Ladungsverschiebeelementen der Einlesekette mit Ausnahme des in Schieberichtung ersten dieser Elemente jeweils eine Grundladungsverschiebekette zur Einführung von Grundladungen zugeordnet ist, die über eine Grundladungsübernahmeelektrode gleichzeitig mit der Übernahmeelektrode angesteuert werden und die Einführung von Grundladungen nach der Übernahme der Informationsladungen in die Parallelketten bewirken, und dass den zweiten Ladungsverschiebeelementen der Auslesekette, in deren in Schieberichtung erstes Ladungsverschiebeelement ebenfalls Grundladungen einführbar sind, Ladungsverschiebeketten zugeordnet sind, die über eine gleichzeitig mit der Übergabeelektrode gesteuerte Verschiebeelektrode angesteuert werden, so dass vor erneuter Übergabe von Informationsladungen aus den Parallelketten in die Ausgabekette die Grundladungen aus der Ausgabekette ausgeräumt werden.

Weiterhin sieht die Erfindung vor, dass die der Einlesekette zugeordneten Grundladungsverschiebeketten jeweils aus einem an die zweiten Ladungsverschiebeelemente angrenzenden dritten Ladungsverschiebeelement, einem an diesem angrenzenden, mit der Grundladungsübernahmeelektrode zusammenwirkenden Ladungsverschiebeelement und aus einem mit Grundladungen aus einer Ladungsquelle sich auffüllenden Speicherelement bestehen.

Eine Lösung für einen in EP-A-9598 vorgeschlagenen SPS-Speicher ist im Anspruch 3 enthalten.

Durch die Erfindung werden wesentliche Fehlermöglichkeiten und Beschränkungen des Arbeitsspeichers von Seriell-Parallel-Seriell-Ladungsverschiebespeichern, insbesondere bei Oberflächen-CDs, beseitigt. Die erfindungsgemäss vorgesehenen Grundladungen der Eingabe- und Ausgabe-Seriellketten vermischen sich nicht mit den Signalladungen. Dadurch ist ihre Bemessung unkritisch. Die einzige Forderung ist, dass ihre Ladungsmenge kleiner ist als die maximale Ladungsmenge in einem Ladungsverschiebeelement. Die Grundladungen dienen lediglich dazu, dafür zu sorgen, dass auch innerhalb der seriellen Ein- und Ausgabeketten kein Ladungsverschiebeelement ladungsfrei bleibt. Die Bewertung der Signalladungen in der Ausgabeschaltung wird durch die neuen Grundladungen nicht erschwert. Es wird ausserdem kein zusätzlicher neuer Ansteuertakt benötigt.

Die Erfindung wird nachstehend anhand der in den Zeichnungen dargestellten Ausführungsformen erläutert. Es zeigen

Fig. 1 eine schematische Darstellung des Layouts einer Eingabe-Seriellkette für einen Ladungsverschiebespeicher mit implantierten Verschiebebereichen in Seriell-Parallel-Seriell-Organisation mit Grundladungsbetrieb,

Fig. 2 eine schematische Darstellung des Impulsdiagrammes zum Betrieb der Eingabe-Seriellkette,

Fig. 3 eine schematische Darstellung des Layouts einer Ausgabe-Seriellkette für einen Ladungsverschiebespeicher mit implantierten Verschiebebereichen in Seriell-Parallel-Seriell-Organisation mit Grundladungsbetrieb,

Fig. 4 eine schematische Darstellung eines Impulsdiagrammes zum Betrieb der Ausgabe-Seriellkette,

Fig. 5 eine schematische Darstellung des Layouts einer Eingabe-Seriellkette für einen Ladungsverschiebespeicher in einfacher Doppelsiliziumtechnologie in sogenannter verdichteter Seriell-Parallel-Seriell-Anordnung mit doppelter Übernahme,

Fig. 6 eine schematische Darstellung des Impulsdiagrammes zum Betrieb der Eingabe-Seriellkette,

Fig. 7 eine schematische Darstellung des Layouts einer Ausgabe-Seriellkette für einen Ladungsverschiebespeicher in einfacher Doppelsiliziumtechnologie in verdichteter Seriell-Parallel-Seriell-Anordnung mit doppelter Übernahme, und

Fig. 8 eine schematische Darstellung des Impulsdiagrammes zum Betrieb der Ausgabe-Seriellkette.

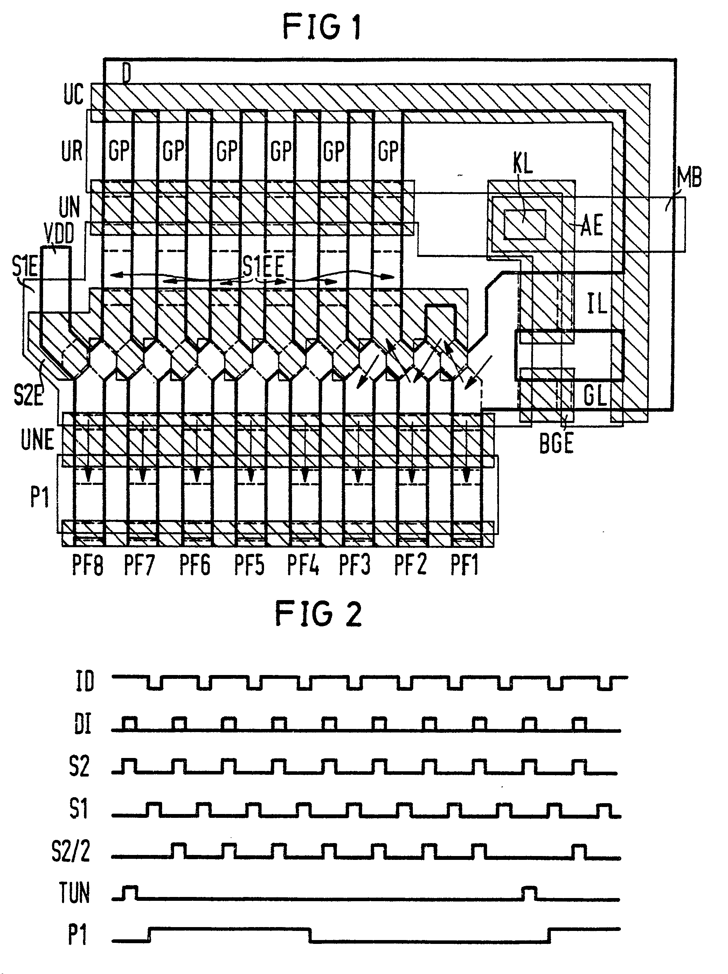

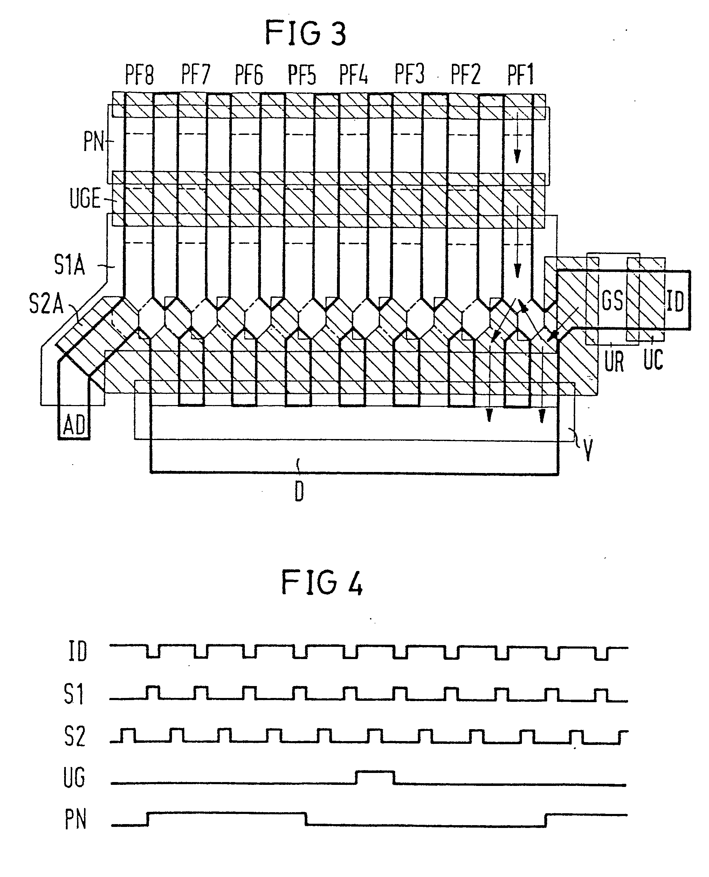

Bei den in den Fig. 1 und 3 mit den zugehörigen Impulsdiagrammen 2 und 4 dargestellten Layouts für Ein-/Ausgabe-Seriellketten handelt es sich um Seriellketten für eine Seriell-Parallel-Seriell-Anordnung im 2-Phasen-Betrieb für n-Kanaloberflächen-CCDs mit implantierten Verschiebebereichen. Als Ladungsverschiebeelemente werden dabei die Verschiebe- und Speicherelektroden definiert. Die eigentlichen Seriellketten sind dabei technologisch in bekannter Weise aufgebaut, wobei die dicken Linien die Grenzen zwischen Dick- und Dünnoxid darstellen. Die linksläufig schraffierten Bereiche bezeichnen die Gebiete mit Silizium-1, die mit dünnen Linien umgebenen Bereiche die mit Silizium-2. KL ist der Bereich des Kontaktloches, über das eine Metallbahn MB kontaktiert ist. Die implantierten Verschiebebereiche sind von Punktlinien umgeben. Der Massstab der gesamten Anordnung beträgt ungefähr 2000:1.

Bei den dargestellten Impulsdiagrammen für die zugeordneten Elektroden verläuft die Zeitachse von links nach rechts, die Ordinate an den einzelnen Impulsdiagrammen bezeichnet die Ansteuerspannung.

Um die Darstellung zu vereinfachen, wird bei den Speicherbausteinen jeweils ein Parallelfeld von nur acht Kanälen PF1 bis PF8 zugrundegelegt. Der Ladungsweg in den Seriellketten verläuft entsprechend den dargestellten Pfeilen von rechts nach links, wobei der Ladungsflussweg in den Seriellketten selbst zickzackförmig gestaltet ist. Dadurch wird erreicht, dass jedes zweite Ladungsverschiebeelement von aussen zugänglich ist.

Betrieben wird die Eingabe-Seriellkette der Fig. 1 in der folgenden Weise: Aus einem Diffusionsgebiet D mit zugehöriger Elektrode UC werden durch ständiges Pulsen des Diffusionsgebietes mit dem Takt ID zum Zeitpunkt des Taktes S1 die Potentialtöpfe unter der Elektrode UR gleichmässig ausgefüllt. Die Informationsladungen IL und ihr beigegebene Basisgrundladungen GL werden durch die Grösse der Speicherbereiche der Elektrode UR bemessen. Die gesamte Informationsladung setzt sich deshalb aus der Basisgrundladung GI und der eigentlichen Informationsladung IL zusammen. Die mit GB bezeichneten Grundladungsbereiche der Elektrode UR bemessen die Grundladungen GP, die der Seriellkette, die aus den Elektroden S2E (Silizium-1) und den Elektroden S1E (Silizium-2) besteht, zugeführt werden.

Beim Einlesen einer Information, z.B. einer «1» über die Metallbahn MB, das Kontaktloch KL und die Ansteuerelektrode AE, wird die Ansteuerelektrode AE mit DI beaufschlagt. Gleichzeitig wird die Elektrode zur Basisgrundladungseingabe BGE mit dem Takt S2 angesteuert. Gleichzeitig damit erfolgt z.B. beim Beginn eines Eingabezyklusses mit dem Takt TUN die Übernahme der in den S1E-Elektroden der Serielkette gespeicherten Information aus dem Vorzyklus in die Übernahmeelektroden UNE der Parallelketten aus den mit GB bezeichneten Elektroden in die Elektroden UN, die den Elektroden S1EE der Kette von Ladungsverschiebeelementen zugeordnet sind, die der Eingabe-Seriellkette vorgeschaltet ist. Der ansonsten zeitgleich mit dem Takt S2 arbeitende Takt S2/2, der die Elektroden S2E der Eingabe-Seriellkette ansteuert, wird unterdrückt. Im nächstfolgenden Takt S1, der die Elektroden S1E und S1EE ansteuert, werden die Grundladungen GP aus den Übernahmeelektroden UN in die Elektroden S1EE übernommen und die Informationsladung IL plus die Basisgrundladung GL in die erste Elektrode S1E der Eingabe-Seriellkette eingespeist. Der nächstfolgende Takt S2/2, der die Elektroden S2E der Eingabe-Seriellkette ansteuert, übernimmt die Grundladung GP in die zweite bis letzte Elektroden S2E der Eingabe-Seriellkette und die Mischladung aus der Informationsladung IL und der Basisgrundladung Gl in die erste Elektrode S2E der Eingabe-Seriellkette.

Die Grundladungen GP werden nun im Takt der einfliessenden Informationsmischladung vor dieser her durch die Eingabe-Seriellkette geschoben und mit Hilfe einer an der Betriebsspannung VDD anliegenden Ladungssenke vernichtet. Nach Übernahme der Informationen tragenden Ladungen in die Übernahmeelektrode UNE der Parallelketten werden mit Hilfe des die ersten Speicherstellen der Parallelketten PF1 bis PF8 ansteuernden Taktes P1 die Ladungen weiter in die Parallelkette verschoben.

Die Ausgabe-Seriellkette der Fig. 3 ist analog zu der Eingabe-Seriellkette der Fig. 1 aufgebaut. Das Parallelfeld aus den Kanälen PF1 bis PF8 steht über eine Übergabeelektrode UGE mit der Ausgabe-Seriellkette mit den aus Silizium-2 bestehenden Elektroden S1A und den aus Silizium-1 bestehenden Elektroden S2A in Verbindung. Die Elektroden S1A werden dabei über den Takt S1 angesteuert, die Elektroden S2A über den Takt S2. Analog zu der Eingabe-Seriellkette ist eine Elektrode UR angeordnet, die über eine Elektrode UC mit einem Diffusionsgebiet D in Verbindung steht, wobei eine erforderliche Grundladung GS unter der Elektrode UR gespeichert wird. Diese Grundladung GS wird im Takte des Ausräumens der Informationsladungen aus der Ausgabe-Seriellkette zum Ausgangsdiffusionsgebiet AD in die Elektroden S2A und S1A der Ausgabe-Seriellkette seriell eingespeist.

Im Unterschied zur Eingabe-Seriellkette ist es bei der Ausgabe-Seriellkette notwendig, vor der Übergabe der Informationsladungen aus dem Parallelfeld mit seinen Parallelkanälen PF1 bis PF8 in die Ausgabe-Seriellkette mit ihren Elektroden S1A und S2A, die in die Ausgabe-Seriellkette im vorangegangenen Zyklus eingespeisten Grundladungen GS parallel aus der Ausgabe-Seriellkette zu entfernen. Dies geschieht mit Hilfe einer parallel zur Ausgabe-Seriellkette angeordneten Verschiebeelektrode V, mit zugeordnetem Diffusionsgebiet D, wobei das Diffusionsgebiet mit der Betriebsspannung VDD beaufschlagt ist. Die Verschiebeelektrode V wird ebenso wie die Übergabeelektrode UGE mit dem Übergabetakt UG beaufschlagt, womit vor Übergabe der die Informationen kennzeichnenden Ladungen aus dem Parallelfeld mit seinen Parallelkanälen PF1 bis PF8, in die Ausgabe-Seriellkette die Grundladungen GS aus der Ausgabe-Seriellkette ausgeräumt werden.

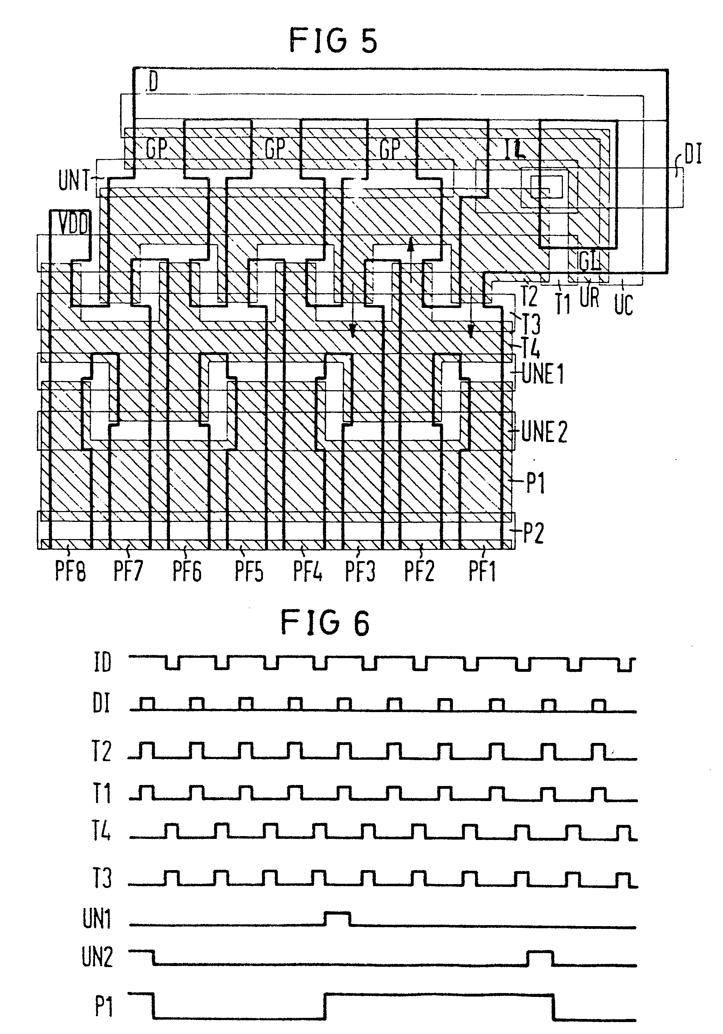

Bei dem in den Fig. 5 bis 8 dargestellten Ausführungsbeispiel handelt es sich um die Layouts der Eingabe- und Ausgabe-Seriellkette eines Ladungsverschiebespeichers in einfacher Doppelsiliziumtechnologie in Seriell-Parallel-Seriell-Organisation in sogenannter verdichteter Anordnung. Bei dem Ladungsverschiebespeicher handelt es sich um einen 4-Phasen-Ladungsverschiebespeicher, der im 2-Phasen-Betrieb betätigt wird. Bei dieser Betriebsweise wird jede zweite Elektrode (Speicherelektrode) zeitgleich mit der benachbarten Verschiebeelektrode angesteuert. Als Ladungsverschiebeelement wird dabei ein Element definiert, das sich aus Speicher- und Verschiebeelektrode zusammensetzt. Der Ladungsverschiebespeicher ist dabei so aufgebaut, dass immer aus den gleichen zweiten Speicherelektroden der seriellen Ein-/Ausgabekette übernommen bzw. übergeben wird. Die abgebende bzw. aufnehmende Elektrode der seriellen Ketten hat dabei zwei Ausgänge bzw. Eingänge zum Parallelfeld, wobei die Übernahme bzw. Übergabe abwechselnd durch den einen oder anderen Ausgang erfolgt. Damit sind jeder abgebenden bzw. aufnehmenden Elektrode der seriellen Ein-/Ausgabekette je zwei Parallelketten im Parallelfeld PF1, PF2; PF3, PF4 usw. zugeordnet.

Bei der in der Fig. 5 dargestellten Eingabe-Seriellkette liegen die Speicherbereiche unter den aus Silizium-1 bestehenden Elektroden T4 und T2 mit den Ansteuertakten TT4, TT2 und die Verschiebebereiche unter den Silizium-2-Elektroden T1 und T3 mit den Ansteuertakten TT1, TT3. Der in die Parallelkette übergebenden Elektrode T4 sind jeweils zwei Übernahmeelektroden UNE1 und UNE2 zugeordnet, mit den jeweiligen zugehörigen Parallelkanälen PF1, PF2 bzw. PF3, PF4 usw. Angesteuert werden die Übernahmeelektroden UNE1 und UNE2 mit den Takten UN1 und UN2, die gemeinsam auch die die Grundladungen GP einspeisenden Elektrode UNT ansteuern. Durch die Form der Elektroden T1 bis T4 der seriellen Eingabekette ergibt sich ein mäanderförmiger Verlauf des Ladungsweges. Die Funktion der Eingabe-Seriellkette ist analog zu der Funktion der Eingabe-Seriellkette der Fig. 1.

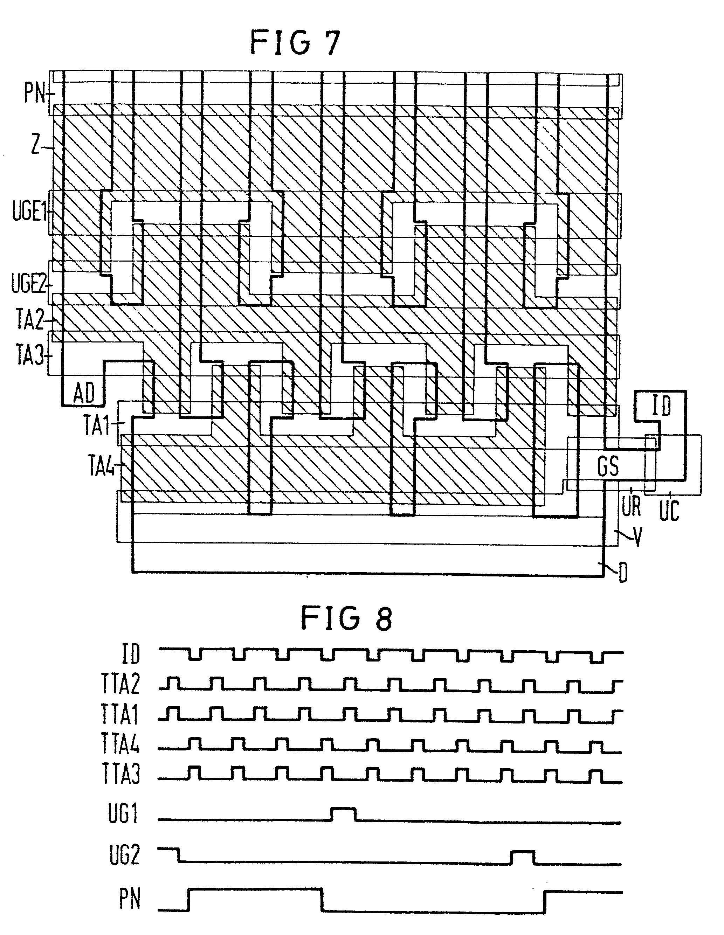

Die Ausgabe-Seriellkette der Fig. 7 entspricht in ihrer Funktion der Eingabe-Seriellkette der Fig. 5.

Die vier Ansteuerelektroden der Ausgabekette TA1 bis TA4 werden ebenfalls über die Takte TT1 bis TT4 angesteuert, wobei auch hier wieder die Speicherbereiche unter den Silizium-1-Elektroden TA4 und TA2 und die Verschiebebereiche unter den Silizium-2-Elektroden TA1 und TA3 liegen. Die Elektroden TA4 und TA3 werden wieder gemeinsam mit den Takten TT4 und TT3 beaufschlagt, dasselbe gilt für die Elektroden TA1 und TA2 mit ihren Takten TT1 und TT2. Verbunden ist die Ausgabe-Seriellkette mit den zugeordneten Parallelketten über die Übergabeelektroden UGE1 und UGE2 mit den Ansteuertakten UG1, UG2, die mit den letzten Speicherelektroden PN der Parallelketten über eine Zwischenspeicherelektrode Z in Verbindung stehen. Die Zwischenspeicherelektrode ist mit einer geeigneten Spannung VCC versehen und speichert die Informationsladungen zur Übergabe in die eigentliche Ausgabe-Seriellkette.

Analog zu der Ausgabe-Seriellkette der Fig. 3 ist die Ausgabe-Seriellkette der Fig. 8 mit einer Verschiebeelektrode V versehen, die gemeinsam mit den Takten UG1 und UG2 angesteuert wird. Ihr zugeordnet ist ein Diffusionsgebiet D, das an der Betriebsspannung VDD liegt, wobei diese Verschiebeelektrode wieder dazu dient, die in die Ausgabe-Seriellkette eingespeisten Grundladungen GS vor der erneuten Übernahme von Informationsladungen aus der Parallelkette auszuräumen. Wie bei der Ausgabe-Seriellkette der Fig. 3 wird im Takt des Auslesens der aus der Parallelkette in die Ausgabe-Seriellkette übernommenen Informationsladungen die Ausgabe-Seriellkette mit den Grundladungen GS gefüllt, womit sich auch für die Ausgabe-Seriellkette ein vollständiger Grundladungsbetrieb ergibt.

**Patentansprüche**

1. Ladeverschiebespeicher in Seriell-Parallel-Seriell-Organisation mit Grundladungsbetrieb, bei dem eine Einlesekette aus abwechselnd hintereinander angeordneten ersten (S1E) und zweiten (S2E) Ladungsverschiebeelementen vorgesehen ist, bei dem den ersten Ladungsverschiebeelementen (S1E) jeweils eine Parallelkette (PF 1–8) zugeordnet ist, in die die Informationen kennzeichnenden Ladungen (IL) aus der Einlesekette über von einer Übernahmeelektrode (UNE) gesteuerte Ladungsverschiebeelemente übernommen werden, bei dem eine Auslesekette aus jeweils abwechselnd hintereinander angeordneten ersten (S1A) und zweiten (S2A) Ladungsverschiebeelementen vorgesehen ist, wobei die Ladungen aus den Parallelketten (PF 1–8) über von einer Übergabeelektrode (VGE) gesteuerten Ladungsverschiebeelement in die erste Ladungsverschiebeelemente (S1A) der Auslesekette übergeben werden, und bei dem in das in Schieberichtung erste Ladungsverschiebeelement der Einlesekette Grundladungen (GL) und Informationsladungen (IL) einführbar sind, dadurch gekennzeichnet, dass den zweiten Ladungsverschiebeelementen (S2E) der Einlesekette mit Ausnahme des in Schieberichtung ersten dieser Elemente jeweils eine Grundladungsverschiebekette zur Einführung von Grundladungen (GP) zugeordnet ist, die über eine Grundladungsübernahmeelektrode (UN) gleichzeitig mit der Übernahmeelektrode (UNE) angesteuert werden und die Einführung von Grundladungen (GP) nach der Übernahme der Informationsladungen (IL) in die Parallelketten (PF) bewirken, und dass den zweiten Ladungsverschiebeelementen (S2A) der Auslesekette, in deren in Schieberichtung erstes Ladungsverschiebeelement ebenfalls Grundladungen (GS) einführbar sind, Ladungsverschiebeketten zugeordnet sind, die über eine gleichzeitig mit der Übergabeelektrode (VGE) gesteuerte Verschiebeelektrode (V) angesteuert werden, so dass vor erneuter Übergabe von Informationsladungen (IL) aus den Parallelketten (PF) in die Ausgabekette die Grundladungen aus der Ausgabekette ausgeräumt werden.

2. Ladeverschiebespeicher nach Anspruch 1, dadurch gekennzeichnet, dass die der Einlesekette zugeordneten Grundladungsverschiebeketten jeweils aus einem an die zweiten Ladungsverschiebeelemente (S2E) angrenzenden dritten Ladungsverschiebeelement (S1EE), einem an diesem angrenzenden, mit der Grundladungsübernahmeelketrode (UN) zusammenwirkenden Ladungsverschiebeelement und aus einem mit Grundladungen (GP) aus einer Ladungsquelle (D) sich auffüllenden Speicherelement bestehen.

3. Ladeverschiebespeicher in Seriell-Parallel-Seriell-Organisation mit Grundladungsbetrieb, bei dem eine Einlesekette aus abwechselnd hintereinander angeordneten ersten (T3, T4) und zweiten (T1, T2) Ladungsverschiebeelementen vorgesehen ist, bei dem den ersten Ladungsverschiebeelementen (T3, T4) jeweils zwei Parallelketten (PF 1–8) zugeordnet sind, in die die Informationen kennzeichnenden Ladungen (IL) aus der Einlesekette über von Übernahmeelektroden (UNE 1 und 2) gesteuerte Ladungsverschiebeelemente übernommen werden, bei dem eine Auslesekette aus jeweils abwechselnd hintereinander angeordneten ersten und zweiten Ladungsverschiebeelementen vorgesehen ist, wobei die Ladungen aus den Parallelketten (PF 1–8) über von Übergabeelektroden (UGE1 und 2) gesteuerten Ladungsverschiebeelement in die zweite Ladungsverschiebeelemente (T1, 2) der Auslesekette übergeben werden, und bei dem in das in Schieberichtung erste Ladungsverschiebeelement der Einlesekette Grundladungen (GL) und Informationsladungen (IL) einführbar sind, bei dem ferner die ersten und zweiten Speicherelektroden (T4 und T2) der Ladungsverschiebeelemente die Form von zwei parallel verlaufenden kammförmig ineinandergreifenden, die Bereiche der Ein-/Auslesekette begrenzenden Bändern aus Silizium-1 bzw. Silizium-2 aufweisen, in deren Verzahnungsbereich die bandförmig parallel verlaufenden ersten und zweiten Verschiebeelektroden (T1, T3) angeordnet sind, so dass sich ein mäanderförmiger Verlauf der Ladungsbahn ergibt und bei dem die Informationen kennzeichnenden Ladungen aus der Einlesekette in die Parallelkette bzw. aus der Parallelkette in die Auslesekette immer aus den ersten (T4) bzw. in die zweiten Speicherelektroden der Ein- bzw. Auslesekette gelesen werden, dadurch gekennzeichnet, dass den zweiten Speicherelektroden (T2) der Einlesekette mit Ausnahme des in Schieberichtung ersten dieser Elemente jeweils eine Grundladungsverschiebekette zur Einführung von Grundladungen (GP) zugeordnet ist, die über eine Grundladungsübernahmeelektrode (VNT) angesteuert werden und die Einführung von Grundladungen (GP) nach der Übernahme der Informationsladungen (IL) in die Parallelketten (PF) bewirken, und dass den ersten Speicherelektroden (T4) der Auslesekette, in deren in Schieberichtung erstes Ladungsverschiebeelement ebenfalls Grundladungen (GS) einführbar sind, Ladungsverschiebeketten zugeordnet sind, die über eine gleichzeitig mit den Übergabeelektroden (UGE1, UGE2) gesteuerte Verschiebeelektrode (V) angesteuert werden, so dass vor erneuter Übergabe von Informationsladungen (IL) aus den Parallelketten (PF) in die Ausgabekette die Grundladungen aus der Ausgabekette ausgeräumt werden.

4. Ladeverschiebespeicher nach einem der vorhergehenden Ansprüche, dadurch gekennzeichnet, dass die der Auslesekette zugeordneten Verschiebeketten jeweils aus einem an die zweiten Ladungsverschiebeelemente (S2A) der Auslesekette angrenzenden, mit der Verschiebeelektrode (V) zusammenwirkenden Ladungsverschiebeelement, die mit einer Ladungssenke in Verbindung steht, bestehen.

## Claims

1. A charge-shift store having serial-parallel-serial organisation with basic charge operation, whrerein there is provided a read-in chain consisting of first (S1E) and second (S2E) charge shift elements consecutively arranged in alternation, wherein the first charge shift elements (S1E) are respectively assigned a parallel chain (PF 1–8), into which the charges (IL) characterising the information are transferred fromt the reas-in chain by means of charge-shift elements controlled by a receiving electrode (UNE), wherein there is provided a read-out chain consisting of first (S1A) and second (S2A) charge shift elements consecutively arranged in alternation, where the charges are transferred from the parallel chains (PF 1–8) into the first charge-shift elements (S1A) of the read-out chain by means of charge-shift elements controlled by a transfer electrode (VGE), and wherein basic charges (GL) and information charges (IL) can be inserted into the first charge-shift element of the read-in chain which is the first one in the direction of shift, characterised in that each of the second charge-shift elements (S2E) of the read-out chain other than the element which is the first one in the direction of shift, is assigned a basic charge-shift chain for introducing basic charges (GP) controlled simultaneously with the receiving electrode (UNE) by means of a basic charge receiving electrode (UN) and which effect the introduction of basic charges (GP) following the receipt of the information charges (IL) in the parallel chains (PF), and that the second charge-shift elements (S2A) of the read-out chain, into whose charge-shift element, which is the first one in the direction of shift, basic charges (GP) can likewise be inserted, are assigned charge-shift chains which are controlled by means of a shift electrode (V) simultaneously controlled with the transfer electrode (VGE), so that the basic charges are removed from the read-out chain before a new transfer of information charges (IL) from the parallel chains (PF) into the read-out chain.

2. A charge shift store as claimed in Claim 1, characterised in that the basic charge-shift chains, which are assigned to the read-in chain, respectively consist of a third charge-shift element (S1EE) adjoining the second charge-shift elements (S2E), of a charge-shift element which adjoins the third charge-shift element and interacts with the basic charge receiving electrode (UN), and of a storage element which fills itself up with basic charges (GP) from a charge source (D).

3. A charge shift store having serial-parallel-serial organisation with basic charge operation, wherein there is provided a read-in chain consisting of first (T3, T4) and second (T1, T2) charge-shift elements consecutively arranged in alternation, wherein the first charge-shift elements (T3, T4) are respectively assigned two parallel chains (PF 1–8), into which the charges (IL) characterising the information are transferred from the read-in chain by means of charge-shift elements controlled by receiving electrodes (UNE 1 and 2), wherein there is provided a read-out chain consisting of first and second charge-shift elements consecutively arranged in alternation, where the charges from the parallel chains (PF 1–8) are transferred into the second charge-shift elements (T1, 2) of the read-out chain by means of transfer electrodes (VGE 1 and 2), and wherein basic charges (GL) and information charges (IL) can be inserted into the charge-shift element of the read-in chain which is the first one in the direction of shift, wherein furthermore the first and second storage electrodes (T4 and T2) of the charge-shift elements have the form of two parallel strips of silicon-1 or silicon-2, as the case may be, engaging one another in a comb-shaped fashion to delimit the regions of the read-in/read-out chain, and in whose tooth system region are arranged the strip-shaped parallel first and second shift electrodes (T1, T3), so that charge path having a meander-shaped course is produced and wherein the charges characterising the information are fed from the read-in chain into the parallel chain or from the parallel chain into the read-out chain always from the first (T4) or into the second storage electrodes of the read-in or read-out chain, as the case may be, characterised in that the second storage electrodes (T2) of the read-in chain other than the element which is the first one in the direction of shift are respectively assigned a basic charge-shift chain for introducing basic charges (GP) which are controlled by means of a basic charge receiving electrode (UNT) and which initiate insertion of basic charges (GP) into the parallel chains (PF) following the receipt of the information charges (IL), and that the first storage electrodes (T4) of the read-out chain, into whose charge-shift element, which is the first one in the direction of shift, basic charges (GS) can likewise be inserted, are assigned charge-shift chains which are controlled by means of a shift electrode (V) simultaneously controlled with the transfer electrodes (VGE1, VGE2), so that the basic charges are removed from the read-out chain before a new transfer of information charges (IL) from the parallel chains (PF) into the output chain.

4. A charge shift store as claimed in one of the preceding claims, characterised in that the shift-chains assigned to the read-out chain respectively consist of a charge-shift element which adjoins the second charge-shift elements (S2A) of the read-out chain and interacts with the shift electrode (V) and is in contact with a charge sink.

**Revendications**

1. Mémoire à transfert de charges en organisation série-parallèle-série en fonctionnement avec des charges de polarisation, dans laquelle est prévue une chaîne de mise en mémoire constituée par des successions alternées de premiers éléments de transfert de charges (S1E) et de seconds éléments de transfert de charges, dans laquelle est associée à chacun des premiers éléments de transfert de charges (S1E) und chaîne parallèle (PF 1–8) dans laquelle sont prises en charge, à partir de la chaîne de mise en mémoire et par l'intermédiare d'éléments de transfert de charges commandés par une électrode de prise en charge (UNE), les charges (IL) qui caractérisent les informations, dans laquelle est prévue une chaîne de lecture constituée par des successions alternées de premiers (S1A) et de seconds (S2A) éléments à transfert de charges, les charges étant transmises à partir des chaînes parallèles (PF 1–8) et par l'intermédiaire d'éléments à transfert de charges commandés par une électrode de transmission (VGE), dans les premiers éléments à transfert de charges (S1A) de la chaîne de lecture, et dans laquelle des charges de polarisation (GL) et des charges d'informations (IL) sont susceptibles d'être introduites dans le premier élément à transfert de charges de la chaîne de mise en mémoire, situé dans le sens du transfert, caractérisé par le fait qu'aux seconds éléments à transfert de charges (S2E) de la chaîne de mise en mémoire, à l'exception du premier de ces éléments, pris dans le sens du transfert, sont respectivement associées des chaînes de transfert de charges pour l'introduction de charges de polarisation (GP), qui, par l'intermédiaire d'une électrode de prise en charge d'une charge de polarisation (UN), sont attaquées simultanément avec l'électrode de prise en charge (UNE) et provoquent l'introduction de charges de polarisation (GP) après la prise en charge des charges d'informations (IL) dans les chaînes parallèles (PF) et qu'aux seconds éléments de transfert de charges (S2A) des chaînes de lecture, dans le premier élément à transfert de charges de laquelle, et se situant dans le sens du transfert, sont également susceptibles d'être introduites des charges de polarisation (GS), sont associées des chaînes à transfert de charges, qui sont attaquées par l'intermédiare d'une électrode de transfert (V) commandée en même temps que l'électrode de transmission (VGE), de manière qu'avant une nouvelle transmission de charges d'informations (IL) des chaînes parallèles (PF) aux chaînes d'émission, les charges de polarisation soient évacuées de cette dernière.

2. Mémoire à transfert de charges selon la revendication 1, caractérisée par le fait que les chaînes à transfert de charges de polarisation, qui sont associées à la chaîne de mise en mémoire, sont chacune constituées par un troisième élément à transfert de charges (S1EE) jouxtant les seconds éléments à transfert de charges (S2E), par un élément à transfert de charges de polarisation jouxtant le troisième élément à transfert de charges (S1EE) et coagissant avec l'élément à transfert de charges de polarisation et par un élément de mémoire se remplissant avec des charges de polarisation (GP) à partir d'une source de charges (D).

3. Mémoire à transfert de charges en organisation série-parallèle-série en fonctionnement avec des charges de polarisation, dans laquelle il est prévu une chaîne de mise en mémoire constituée par une succession alternée de premiers (T3, T4) et de seconds (T1, T2) éléments à transfert de charges, dans laquelle aux premiers éléments à transfert de charges (T3, T4) sont respectivement associées deux chaînes parallèles (PF 1–8) dans lesquelles sont prises en charge, à partir de la chaîne de mise en mémoire et par l'intermédiaire d'éléments à transfert de charges commandés par des électrodes de prise en charge (UNE 1 et 2), les charges (IL) qui caractérisent les informations, dans laquelle il est prévu une chaîne de lecture constituée par une succession alternée de premiers et de seconds éléments à transfert de charges, les charges étant transmises à partir des chaînes parallèles (PF 1–8) et par l'intermédiaire d'éléments à transfert de charges commandés par des électrodes de transfert (VGE 1 et 2), dans les seconds éléments à transfert de charges (T1, T2) de la chaîne de lecture, et dans laquelle des charges de polarisation (GL) et des charges d'informations (IL) sont susceptibles d'être introduites dans le premier élément de transfert de charges de la chaîne de mise en mémoire, dans le sens de transfert, dans laquelle, en outre, les premières et secondes électrodes de mémorisation (T4 et T2) des éléments à transfert de charges, présentent la forme de deux bandes de silicium-1 et de silicium-2, qui s'étendent parallèlement, qui pénètrent entre elles à la manière de peignes et qui limitent les zones de la chaîne d'écriture/lecture, et dans les zones dentées desquelles sont disposées les premières et secondes électrodes de transfert (T1, T3) qui s'étendent parallèlement et en forme de bandes, en sorte qu'il en résulte pour les charges une trajectoire en forme de méandres, et dans laquelle les charges qui caractérisent les informations sont extraites des chaînes de mise en mémoire et introduites dans la chaîne parallèle ou de la chaîne parallèle dans la chaîne de lecture, toujours à partir des premières (T4) ou dans les secondes électrodes de mise en mémoire des chaînes de mise en mémoire ou des chaînes de lecture, caractérisée par le fait qu'aux secondes électrodes de mise en mémoire (T2) de la chaîne de mise en mémoire, à l'exception du premier de ces éléments dans le sens du transfert, sont respectivement associées des chaînes à transfert de charges de polarisation pour l'introduction de charges de polarisation (GP) qui sont attaquées par l'intermédiaire d'une électrode de prise en charge de charges de polarisation (UNT) et qui provoquent l'introduction de charges de polarisation (GP) après la prise en charge des charges d'informations (IL) par les chaînes parallèles (PF), et qu'aux premières électrodes de mise en mémoire (T4) de la chaîne de lecture, dans le premier élément à transfert de charges de laquelle, pris dans le sens du transfert, sont également susceptibles d'être introduites des charges de polarisation (GL), sont associées des chaînes à transfert de charges qui sont attaquées par une électrode de transfert (V) commandée en même temps que les électrodes de transmission (UGE1, UGE2), en sorte qu'avant une nouvelle transmission de charges d'informations (IL), des chaînes parallèles (PF) à la chaîne d'émission, les charges de polarisation sont évacuées de la chaîne d'émission.

4. Mémoire à transfert de charges selon l'une des revendications précédentes, caractérisée par le fait que les chaînes à transfert associées aux chaînes de lecture sont chacune constituées par un élément à transfert de charges qui jouxte des seconds éléments à transfert de charges (S2A) de la chaîne de lecture, qui coagit avec l'électrode de transfert (V), et qui est en liaison avec un puits de charges.

# FIG 1

# FIG 2

# FIG 3

PF8　PF7　PF6　PF5　PF4　PF3　PF2　PF1

PN

UGE

S1A

S2A

GS　ID

UR　UC

AD

V

D

# FIG 4

ID

S1

S2

UG

PN

# FIG 5

# FIG 6

# FIG 7

PN—
Z—
UGE1—
UGE2—
TA2—
TA3—
AD
TA1—
TA4—

ID
GS
UR  UC
V
D

# FIG 8

ID
TTA2
TTA1
TTA4
TTA3
UG1
UG2
PN